# EUROPEAN PATENT APPLICATION

(11) **EP 4 296 690 A1**
(43) Date of publication of application: **27.12.2023**
(21) Application number: 22180230.9
(22) Date of filing: 21.06.2022
(51) Int. Cl.: G01Q 30/14, G01Q 70/10, H01L 21/66

(54) **METHOD OF MEASURING FEATURE WITH PROBE MICROSCOPE**

(71) Applicant: Infinitesima Limited, Abingdon, Oxfordshire OX14 1RG (GB)
(72) Inventor: The designation of the inventor has not yet been filed
(74) Representative: Ribeiro, James Michael

(57) **Abstract**

A method of measuring a feature with a probe microscope. The feature comprises a base, an entrance, and a pair of opposed side walls. The feature is filled with a liquid. The probe microscope comprises a cantilever and a probe tip extending from the cantilever. The method comprises: inserting the probe tip into the feature via the entrance; and performing a measurement of the feature by contacting the base of the feature with the probe tip.

## Description

### FIELD OF THE INVENTION

The present invention relates to a method of measuring a feature with a probe microscope.

### BACKGROUND OF THE INVENTION

A scanning probe system is disclosed in US10969404. A high aspect ratio probe tip scans a trench in a sample surface.

A problem with the method of US10969404 is that it can be difficult to insert the probe tip into the trench.

### SUMMARY OF THE INVENTION

An aspect of the invention provides a method according to claim 1.

Optionally at least part of the probe tip has a bending spring constant which is less than 1N/m or less than 2N/m or less than 5N/m.

Optionally at least part of the probe tip has an aspect ratio which is greater than 5 or greater than 10 or greater than 20.

Optionally the probe tip comprises an inserted probe tip portion which is inserted into the feature, and at least part of the inserted probe tip portion has an aspect ratio which is greater than 5 or greater than 10 or greater than 20.

Optionally as the probe tip contacts the base, the probe tip has a width Wₑₙₜ at the entrance and a length L inside the feature between the entrance and the base, and a ratio L/Wₑₙₜ is greater than 5 or greater than 10 or greater than 20.

Optionally at least part of the probe tip has a length L and a maximum width Wₘₐₓ, and a ratio L/Wₘₐₓ is greater than 5 or greater than 10 or greater than 20.

Optionally as the probe tip contacts the base, the probe tip has a maximum width inside the feature which is less than 30nm or less than 20nm or less than 10nm.

Optionally as the probe tip contacts the base, the probe tip has a width at the entrance which is less than 30nm or less than 20nm or less than 10nm.

Optionally at least part of the probe tip has a probe tip sidewall angle which is less than 20degrees or less than 10degrees.

Optionally the feature has a feature width W between the side walls and a feature depth D between the base and the entrance, and a ratio D/W is greater than 5 or greater than 10 or greater than 20.

Optionally the feature has a feature width Wₑₙₜ between the side walls at the entrance and a feature depth D between the base and the entrance, and a ratio D/Wₑₙₜ is greater than 5 or greater than 10 or greater than 20.

Optionally the feature has a feature width Wₑₙₜ between the side walls at the entrance and a feature depth D between the base and the entrance; as the probe tip contacts the base an inserted probe tip portion of the probe tip is inside the feature and a reserve probe tip portion of the probe tip is outside the feature; the inserted and reserve probe tip portions each have a maximum width which is less than the feature width Wₑₙₜ between the side walls at the entrance; and a combined length of the inserted and reserve probe portions is more than 10% greater than the feature depth D, or more than 20% greater than the feature depth D or more than 40% greater than the feature depth D.

Optionally the feature has a feature width between the side walls which is less than 50nm, or less than 30nm, or less than 20nm, or less than 10nm.

Optionally the feature has a feature width between the side walls at the entrance which is less than 50nm, or less than 30nm, or less than 20nm, or less than 10nm.

Optionally the feature has a depth from the entrance to the base which is greater than 50nm or greater than 100nm.

Optionally the probe tip moves in an insertion direction as it is inserted into the feature, and at least part of each side wall is parallel to the insertion direction, or inclined to the insertion direction at a sidewall angle which is less than 20degrees or less than 10degrees or less than 5degrees.

Optionally the feature is a feature of a semiconductor device.

Optionally the feature is formed in a layer of resist material.

Optionally the cantilever and the probe tip are immersed in the liquid.

Optionally the liquid is a polar liquid.

Optionally the method comprises comprising inserting the probe tip repeatedly into the feature via the entrance, and for each repeat performing a measurement of the feature by contacting a different part of the base with the probe tip.

Optionally the feature comprises a trench, hole, recess, pit or other indented feature.

Optionally performing a measurement of the feature comprises measuring a depth of the feature.

### BRIEF DESCRIPTION OF THE DRAWINGS

Embodiments of the invention will now be described with reference to the accompanying drawings, in which:
Figure 1 is a schematic view of a scanning probe microscopy system;
Figure 2 shows the system of Figure 1 after the cell has been filed with a liquid;
Figure 3 is an end view of the probe;
Figure 4 shows a distal portion of the probe tip;
Figure 5 is a cross-sectional view of a feature;
Figure 6 shows the probe tip of Figure 4 being inserted into the feature of Figure 5;
Figure 7 shows the probe tip of Figure 4 contacting a base of the feature of Figure 5;
Figure 8 shows three measurement points of the base of the feature;
Figure 9 shows a probe tip with a curved tapering shape;
Figure 10 shows a flared probe tip;
Figure 11 shows a high aspect ratio feature;
Figure 12 shows a distal portion of a very high aspect ratio probe tip;
Figure 13 shows the very high aspect ratio probe tip of Figure 12 contacting a base of the high aspect ratio feature of Figure 11;
Figure 14 is a cross-sectional view of a feature with inclined sidewalls;
Figures 15-17 are cross-sectional views of alternative features, showing their depth, and their width at the entrance.

### DETAILED DESCRIPTION OF EMBODIMENT(S)

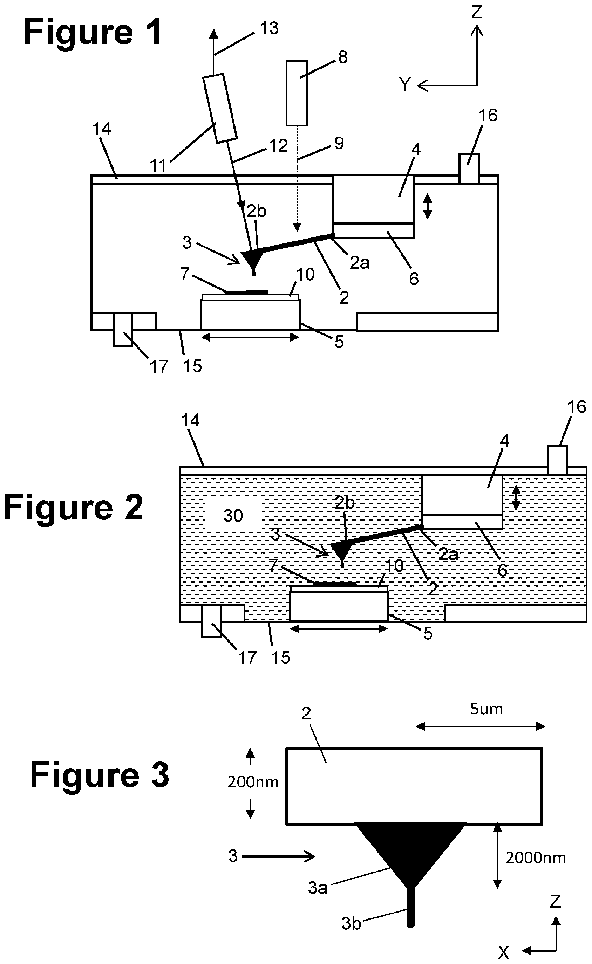

A scanning probe microscopy system according to an embodiment of the invention is shown in Figure 1. The system comprises a Z-driver 4 and a probe comprising a cantilever 2 and a probe tip 3. The bottom of the Z-driver 4 carries a cantilever mount 6, with the cantilever 2 extending from the cantilever mount 6 from a proximal end or base 2a to a distal free end 2b. The probe tip 3 is carried by the free end 2b of the cantilever 2.

The probe tip 3 is shown with its axis extending generally vertically (that is, in the -Z direction based on the frame of reference shown in Figure 1). The cantilever 2 comprises a single beam with a rectangular profile extending from the cantilever mount 13. The cantilever 2 has a length of about 20 micron, a width of about 10 micron, and a thickness of about 200nm.

In an alternative embodiment, as described in US10969404 (the disclosure of which is incorporated herein by reference), the cantilever 2 may comprise a pair of cantilever arms rather than a single arm.

The system of Figure 1 is used to measure a sample 7, which may be a semiconductor device for example.

The cantilever 2 is a thermal bimorph structure composed of two (or more) materials, with differing thermal expansions - typically a silicon or silicon nitride base with a gold or aluminium coating. The coating extends the length of the cantilever and covers the reverse side from the probe tip 3. An illumination system (in the form of a laser 8) under the control of an actuation controller (not shown) is arranged to illuminate the cantilever on its upper coated side with an intensity-modulated actuation beam 9.

The cantilever 2 may be formed from a monolithic structure with uniform thickness. For example the monolithic structure may be formed by selectively etching a thin film of SiO2 or SiN4 as described in Albrecht T., Akamine, S., Carver, T.E., Quate, C.F. J., Microfabrication of cantilever styli for the atomic force microscope, Vac. Sci. Technol. A 1990, 8, 3386 (hereinafter referred to as "Albrecht et al."). The probe tip 3 may be formed integrally with the cantilever, as described in Albrecht et al., it may be formed by an additive process such as electron beam deposition, or it may be formed separately and attached by adhesive or some other attachment method.

The wavelength of the actuation beam 9 is selected for good absorption by the coating, so that the cantilever 2 bends along its length and moves the probe tip 3. In this example the coating is on the reverse side from the sample 7 so the cantilever 2 bends down towards the sample 7 when heated, but alternatively the coating may be on the same side as the sample so the cantilever 2 bends away from the sample 7 when heated.

The Z-driver 4 is a piezoelectric actuator which expands and contracts up and down in the Z-direction to move the probe repeatedly towards and away from the sample 7 on a sample stage 10 in a series of cycles.

An interferometer detector 11 is arranged to detect a height of the free end 2b of the cantilever 2 directly opposite to the probe tip 3 using a detection beam 12. Further details of a suitable interferometer detector are given in US10969404.

The output of the detector 11 is a height signal on a height detection line 13 which is processed to determine a profile of the surface of the sample 7, for instance using a surface detector which detects when the probe tip contacts the sample 7 as described in US10969404.

Horizontal scanning in the X and Y directions is achieved in this example by moving the sample with an XY actuator 5. In an alternative embodiment, horizontal scanning may be achieved by moving the probe 2, 3.

The probe 2, 3; sample 7; and actuators 4, 5 are housed in a closed cell with a transparent window 14 through which the detection beam 12 and actuation beam 9 can pass on the way to the probe 3. The XY actuator 5 is carried on a flexible diaphragm 15.

The closed cell can be filled with liquid via an inlet port 16 and emptied of liquid via an outlet port 17. The closed cell is shown in Figure 1 with no liquid and in Figure 2 filled with a liquid 30 which fully immerses the sample 7 and the probe 2, 3 (including the full length of the cantilever 2).

This method of immersing the sample 7 is illustrative only, and other methods may be used. For instance an open cell may be used which immerses only the sample 7 and part of the probe tip 3 in liquid. Such an open cell does not immerse the cantilever 2 in liquid and does not require a transparent window 14.

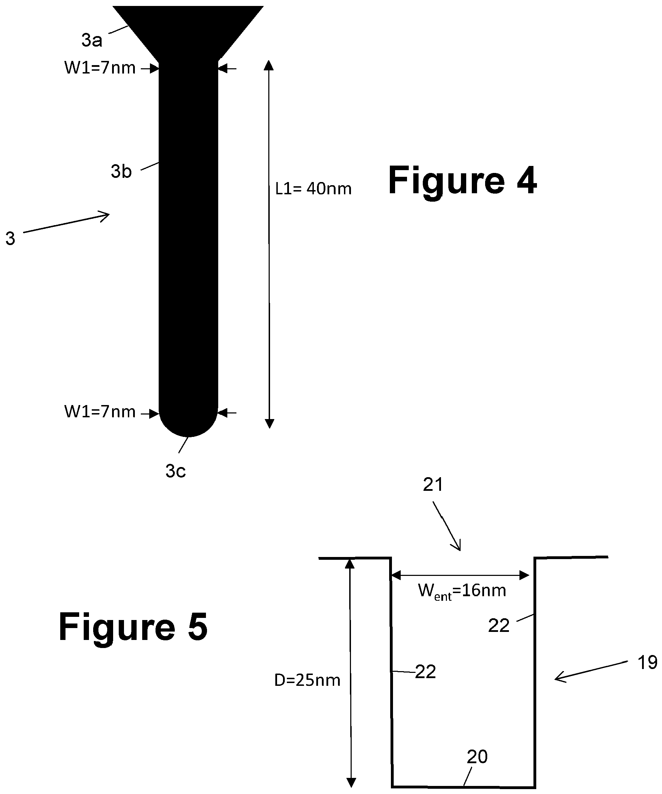

Figures 3 and 4 show the probe tip 3 extending from the cantilever 2, viewed in the Y-direction. The probe tip 3 has a probe tip base 3a in the form of a low aspect-ratio cone or pyramid, and a distal portion 3b in the form of a high aspect-ratio spike or whisker which extends from an apex of the probe tip base 3a.

As shown in Figure 3, the probe tip base 3a has a dimension in the Z-direction of about 2000nm and a cone angle of about 80 degrees. Figure 4 shows the apex of the probe tip base 3a, and the full length of the distal portion 3b. The distal portion 3b comprises an approximately cylindrical shaft with a width W1 of about 7nm which terminates at a sharp apex 3c with a width of about 7nm and a tip radius of about 3.5nm. A length L1 of the distal portion 3b (from the point where it meets the probe tip base 3a to its apex 3c) is about 40nm, so the length-to-width aspect ratio L1/W1 of the distal portion 3b is moderately high - about 5.7.

The distal portion 3b of the probe tip has an aspect ratio L1/W1 which is greater than 5 - in this case about 5.7. Alternatively the aspect ratio L1/W1 may be greater than 10 or greater than 20.

Figure 5 shows a feature 19 formed in the upper surface of the sample 7. The feature comprises a base 20, an entrance 21, and a pair of opposed side walls 22. The feature 19 may be a trench, hole, recess, pit or any other indented feature. The side walls 22 may be planar walls of a trench which extends in and out of the plane of the figure, convex outer side walls of cylindrical pillars, concave side walls of a cylindrical recess or pit, or any other shape.

The feature 19 has a width Wₑₙₜ of about 16nm between the side walls 22 at the entrance 21, and approximately the same width at the base 20. The feature 19 also has a feature depth D (between the base 20 and the entrance 21) of about 25nm, so the depth-to-width aspect ratio D/Wₑₙₜ of the feature 6 is moderately low - about 1.6.

The total clearance between the probe tip and the side walls is about 9nm, so it should be easy to insert the probe tip 3 into the feature 19 and into contact with the base 20. However, it has been found to be surprisingly difficult to do so. Without wishing to be bound by theory, it is speculated that this difficulty is caused by attractive forces bending the distal portion 3b of the probe tip into contact with one of the side walls 22.

Such bending of the distal portion 3b is made easier by its relatively low bending spring constant. For example the distal portion 3b of the probe tip may have a bending spring constant which is less than 1N/m or less than 2N/m or less than 5N/m. The bending spring constant may be measured by an atomic force microscope or calculated based on its geometry and material properties.

One solution to this tip-bending problem may be to make the probe tip more stiff, for instance by changing its material or reducing its aspect ratio. However a change of material may not be possible, and a reduction of aspect ratio may make it more difficult to probe a feature which is deep, and/or has a narrow entrance, and/or has steep side walls, and/or has a high aspect-ratio.

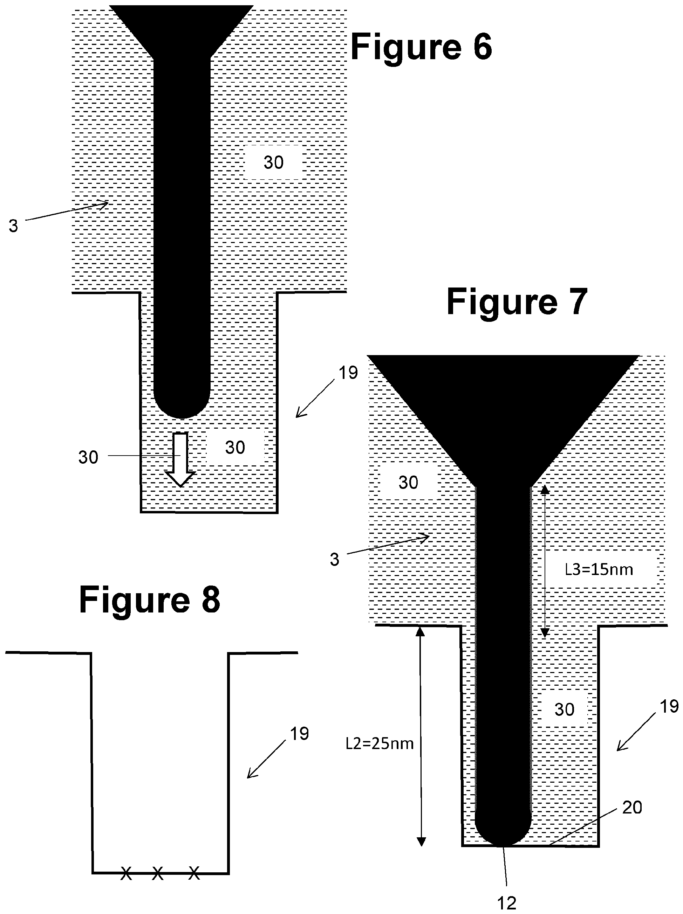

A more preferred solution to this tip-bending problem is to fill the feature with liquid 30 as shown in Figures 6 and 7. The probe tip is inserted into the feature 19 via the entrance 21 as shown in Figure 6, then a measurement of the feature 19 is performed by contacting the base 20 with the probe tip as shown in Figure 7. Without wishing to be bound by theory, it is speculated that the liquid 30 prevents the attractive forces from the side walls 22 acting so strongly on the probe tip. This makes it easier to insert the probe tip into the feature 19 and into contact with the base 20.

Preferably the liquid 30 is a polar liquid, such as an alcohol or water. A polar liquid is expected to neutralise the attractive forces from the side walls 22 more effectively than a non-polar liquid.

As the probe tip contacts the base 20, the probe tip has an inserted probe tip portion which is inside the feature 19 (length L2=25nm) and a reserve probe tip portion which is outside the feature (length L3=15nm). The first and reserve probe tip portions each have a maximum width W1 which is less than the feature width Wₑₙₜ between the side walls 22 at the entrance 21. A combined length (L1=40nm) of the first and reserve probe tip portions is about 60% greater than the feature depth (D=25nm). This is beneficial since it enables the probe tip 3 to continue to be used, even if the probe tip 3 wears away by up to 15nm. Thus the reserve probe tip portion provides a reserve which can be used in the event of tip wear.

The distal portion 3b of the probe tip is approximately cylindrical, so it has a probe tip sidewall angle of about zero (the probe tip sidewall angle being defined as an angle between a sidewall of the probe and a length axis of the probe, viewed in cross-section through the apex 3c of the probe tip as shown in Figure 4). Alternatively, the distal portion 3b of the probe tip may be conical with a probe tip sidewall angle (in this case the half-cone angle) which is less than 20degrees, less than 10degrees, or less than 5degrees. Other shapes are possible for the distal portion 3b of the probe tip - for instance it may be a pyramid with a square cross-section or a tetrahedron with a triangular cross-section. In all cases, a low probe tip sidewall angle is beneficial because it maintains sharpness of the probe tip as it wears away.

The aspect ratio L2/W1 of the inserted probe tip portion which is inside the feature 6 is about 3.6. Alternatively the aspect ratio L2/W1 may be greater than 5 or greater than 10 or greater than 20.

Optionally the base 20 is imaged by inserting the probe tip repeatedly into the feature via the entrance 21, and for each repeat performing a measurement of the feature 19 by contacting a different part of the base 20 with the probe tip. Figure 8 shows three measurement points, each marked by an X. These measurements may be used to form an image of the feature, to provide a critical-dimension measurement of the depth of the feature, or for any other purpose.

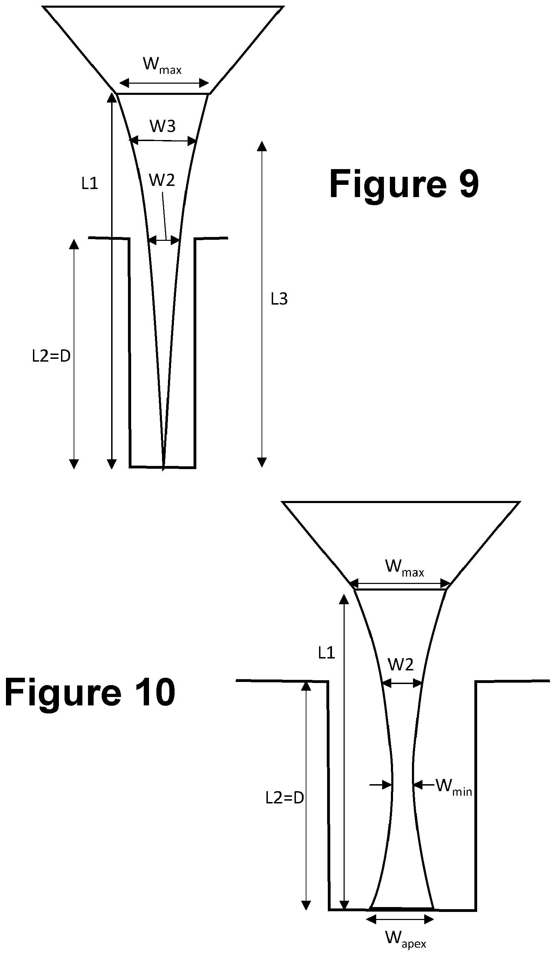

Figures 9 and 10 show example of different shapes of probe tip which may be used in the present invention. The feature is filled with a liquid but for ease of illustration the liquid is not shown in Figures 9 and 10.

The probe tip of Figure 9 has a distal portion with a curved tapering shape, with a maximum width Wₘₐₓ at its root where it meets the probe tip base, and a length L1.

As the probe tip contacts the base of the feature, the probe tip has an inserted probe tip portion which is inside the feature (length L2=D, maximum width W2 at the entrance to the feature); and a reserve probe tip portion which is outside the feature (maximum width W3).

The inserted probe tip portion has a maximum width W2 and the reserve probe tip portion has a maximum width W3 which is less than the feature width between the side walls at the entrance. A combined length (L3) of the first and reserve probe tip portions is about 40% greater than the feature depth D. This is beneficial since it enables the probe tip to continue to be used to probe the feature, even if the probe tip wears away.

The distal portion of the probe tip has an aspect ratio L1/Wₘₐₓ which is about 4. Alternatively the aspect ratio L1/Wₘₐₓ may be greater than 5 or greater than 10 or greater than 20.

The aspect ratio L2/W2 of the inserted probe tip portion which is inside the feature is greater than 5 - in this case about 7. Alternatively the aspect ratio L2/W2 may be greater than 10 or greater than 20.

The distal portion of the probe tip of Figure 9 may have a bending spring constant which is less than 1N/m or less than 2N/m or less than 5N/m. The bending spring constant may be measured by an atomic force microscope or calculated based on its geometry and material properties.

The probe tip sidewall angle is low at the apex of the probe tip and increases away from the apex. The minimum probe tip sidewall angle may be less than 20degrees, less than 10degrees, or less than 5degrees. A low probe tip sidewall angle is beneficial because it maintains sharpness of the probe tip as it wears away.

The probe tip of Figure 10 has a distal portion with a flared apex. The distal portion has a maximum width Wₘₐₓ, a minimum width Wₘᵢₙ, a width Wₐₚₑₓ at its flared apex, and a length L1.

As the probe tip contacts the base, the probe tip has an inserted probe tip portion which is inside the feature (length L2=D) and a reserve probe tip portion which is outside the feature. The inserted probe tip portion has a maximum width Wₐₚₑₓ and the reserve probe tip portion has a maximum width Wₘₐₓ which is less than the feature width between the side walls at the entrance. As the probe tip contacts the base of the feature, the probe tip has a length L2=D inside the feature and a width W2 at the entrance.

A combined length (L1) of the first and reserve probe tip portions is about 40% greater than the feature depth D. This is beneficial since it enables the probe tip to continue to be used to probe the feature, even if the flared apex of the probe tip wears away.

The distal portion of the probe tip has an aspect ratio L1/Wₘₐₓ which is about 3. Alternatively the aspect ratio L1/Wₘₐₓ may be greater than 5 or greater than 10 or greater than 20.

The aspect ratio L2/W2 of the inserted probe tip portion which is inside the feature is greater than 5 - in this case about 6. Alternatively the aspect ratio L2/W2 may be greater than 10 or greater than 20.

The distal portion of the probe tip of Figure 10 may have a bending spring constant which is less than 1N/m or less than 2N/m or less than 5N/m. The bending spring constant may be measured by an atomic force microscope or calculated based on its geometry and material properties.

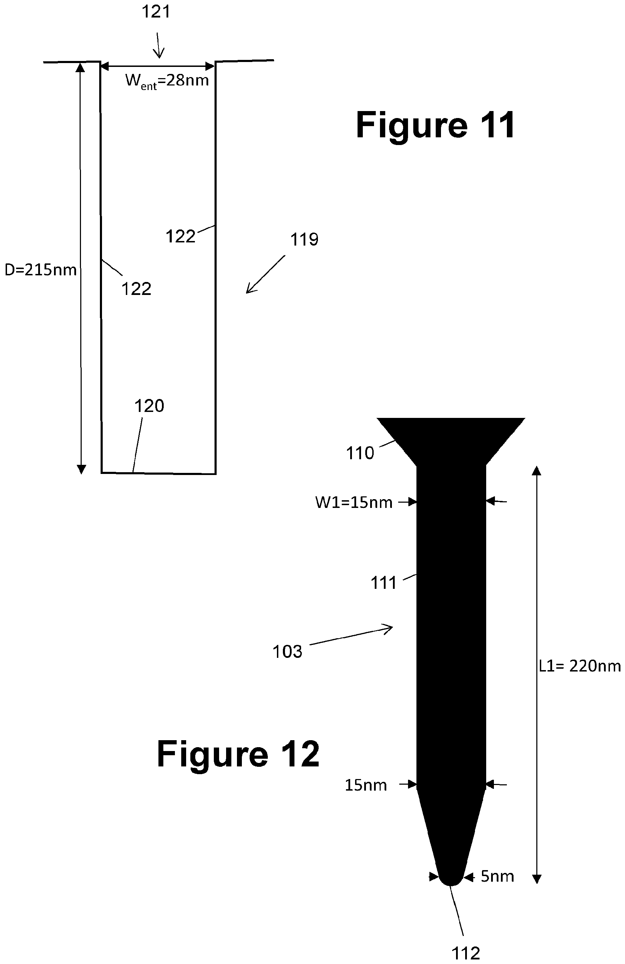

Figure 11 shows a high aspect-ratio feature 119 formed in the upper surface of a sample. The feature 119 comprises a base 120, an entrance 121, and a pair of opposed side walls 122. The feature 119 may be a trench, hole, recess, pit or any other indented feature. The side walls 122 may be planar walls of a trench which extends in and out of the plane of the figure, convex outer side walls of cylindrical pillars, concave side walls of a cylindrical recess or pit, or any other shape.

The feature 119 has a width Wₑₙₜ of about 28nm between the side walls 122 at the entrance 121, and approximately the same width at the base 120. The feature 119 has a feature depth D (between the base 120 and the entrance 121) of about 215nm, so the depth-to-width aspect ratio D/Wₑₙₜ of the feature 119 is high - about 8.

Figure 12 shows part of a probe tip 103, viewed in the Y-direction. The probe tip 103 has a probe tip base 110 in the form of a low aspect-ratio cone and a distal portion 111 in the form of a high aspect-ratio spike or whisker which extends from an apex of the probe tip base 110.

Figure 12 shows only the apex of the probe tip base 110, and the full length of the distal portion 111. The distal portion 111 comprises an approximately cylindrical shaft with a width W1 of about 15nm which terminates at a sharp apex 112 with a width of 5nm and a tip radius of about 2.5nm. A length L1 of the distal portion 111 (from the point where it meets the probe tip base 110 to its apex 112) is about 220nm, so the length-to-width aspect ratio L1/W1 of the distal portion 11 is very high - about 15.

The distal portion of the probe tip 103 of Figure 12 may have a bending spring constant which is less than 1N/m or less than 2N/m or less than 5N/m. The bending spring constant may be measured by an atomic force microscope or calculated based on its geometry and material properties.

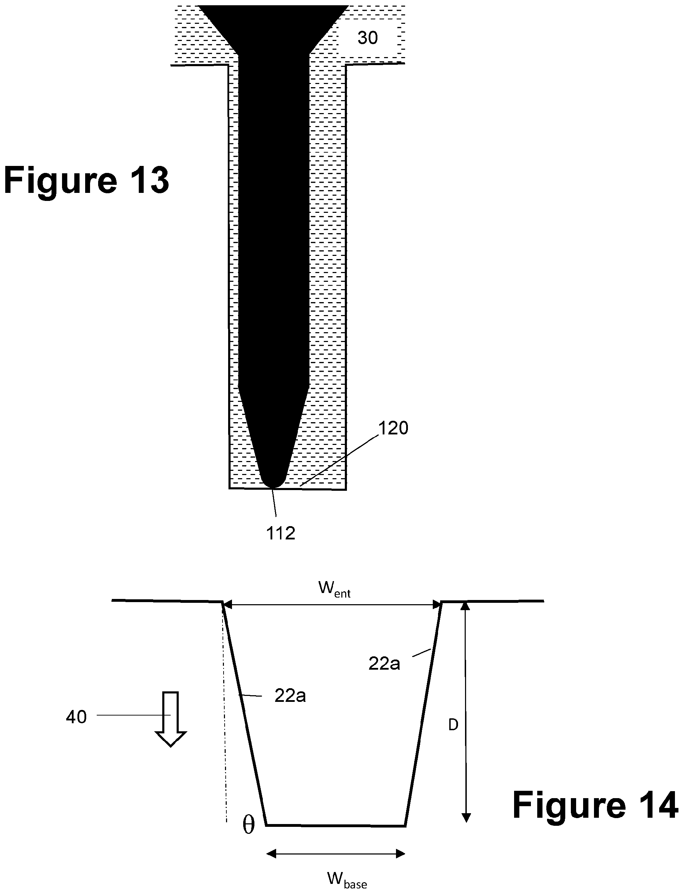

The probe tip 103 is inserted into the feature 119 via the entrance 121, then a measurement of the feature 119 is performed by contacting the base 120 with the probe tip as shown in Figure 13. The feature 119 is filled with the liquid 30 for the measurement of Figure 13.

In the examples above, the feature 19, 119 has vertical sidewalls, parallel to a vertical (Z) insertion direction of the probe tip. In alternative embodiments of the invention, the probe tip may be used to probe a feature with non-vertical sidewalls - for instance where each side wall is inclined to the insertion direction at a constant or varying angle.

Figure 14 gives an example feature with sidewalls 22a inclined at a sidewall angle θ relative to the (vertical) insertion direction 40. The sidewall angle θ may be positive as shown in Figure 14, or the sidewalls may be overhanging so the sidewall angle θ is negative. In either case a magnitude of the sidewall angle θ is preferably relatively small - for instance less than 20degrees or less than 10degrees or less than 5degrees.

In the examples above, the feature has straight sidewalls 22, 22a, 122 (viewed in cross-section) but in other embodiments the sectional shape of the sidewalls may be curved, stepped, or of any other shape. In this case at least part of each side wall may be parallel to the insertion direction 40, or inclined to the insertion direction 40 at a sidewall angle which is less than 20degrees or less than 10degrees or less than 5degrees.

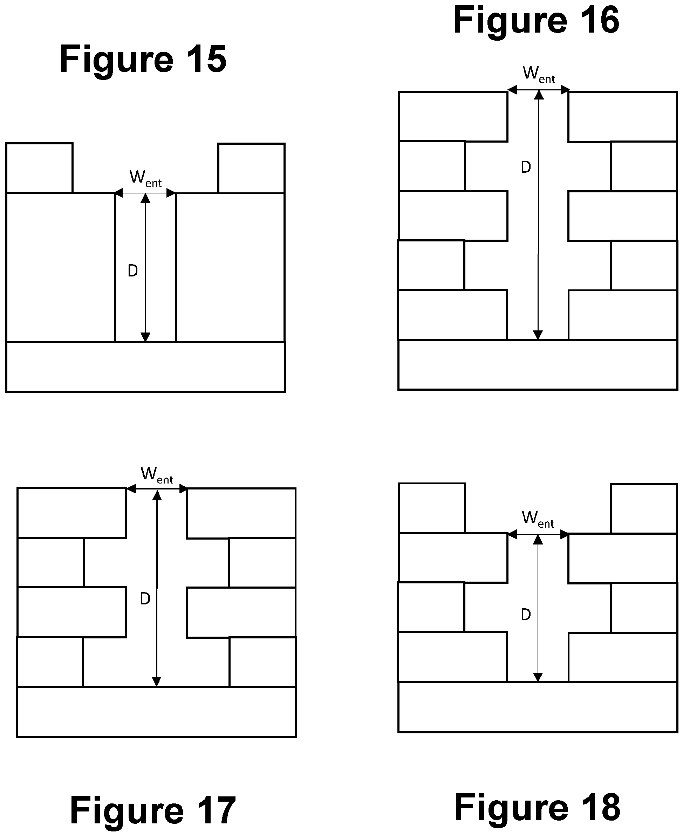

Figures 15-18 show examples of other features which may be imaged in liquid with one of the probes described above. For each feature the width Wₑₙₜ between the side walls at the entrance is shown, along with the depth D. In this case the vertical parts of the side walls are parallel to the insertion direction, but in other examples they may be inclined, curved or any other shape.

In the examples above, the feature 19, 119 has a feature width Wₑₙₜ between the side walls at the entrance of 28nm or 16nm. In other embodiments the feature may have a feature width between the side walls which is less than 10nm. In this case the feature may be formed in a layer of resist material which is used in a high numerical aperture EUV lithography process.

Although the invention has been described above with reference to one or more preferred embodiments, it will be appreciated that various changes or modifications may be made without departing from the scope of the invention as defined in the appended claims.

## Claims

1. A method of measuring a feature with a probe microscope, the feature comprising a base, an entrance, and a pair of opposed side walls, wherein the feature is filled with a liquid; the probe microscope comprising a cantilever and a probe tip extending from the cantilever, the method comprising: inserting the probe tip into the feature via the entrance; and performing a measurement of the feature by contacting the base of the feature with the probe tip.

2. A method according to claim 1 wherein at least part of the probe tip has a bending spring constant which is less than 1N/m or less than 2N/m or less than 5N/m.

3. A method according to any preceding claim wherein at least part of the probe tip has an aspect ratio which is greater than 5 or greater than 10 or greater than 20.

4. A method according to any preceding claim wherein the probe tip comprises an inserted probe tip portion which is inserted into the feature, and at least part of the inserted probe tip portion has an aspect ratio which is greater than 5 or greater than 10 or greater than 20.

5. A method according to any preceding claim wherein as the probe tip contacts the base, the probe tip has a width Wₑₙₜ at the entrance and a length L inside the feature between the entrance and the base, and a ratio L/Wₑₙₜ is greater than 5 or greater than 10 or greater than 20.

6. A method according to any preceding claim wherein as the probe tip contacts the base, the probe tip has a maximum width inside the feature which is less than 30nm or less than 20nm or less than 10nm.

7. A method according to any preceding claim wherein at least part of the probe tip has a probe tip sidewall angle which is less than 20degrees or less than 10degrees.

8. A method according to any preceding claim the feature has a feature width W between the side walls and a feature depth D between the base and the entrance, and a ratio D/W is greater than 5 or greater than 10 or greater than 20.

9. A method according to any preceding claim the feature has a feature width Wₑₙₜ between the side walls at the entrance and a feature depth D between the base and the entrance, and a ratio D/Wₑₙₜ is greater than 5 or greater than 10 or greater than 20.

10. A method according to any preceding claim wherein the feature has a feature width between the side walls which is less than 50nm, or less than 30nm, or less than 20nm, or less than 10nm.

11. A method according to any preceding claim wherein the feature has a depth from the entrance to the base which is greater than 50nm or greater than 100nm.

12. A method according to any preceding claim wherein the feature is a feature of a semiconductor device.

13. A method according to any preceding claim wherein the liquid is a polar liquid.

14. A method according to any preceding claim wherein the feature comprises a trench.

15. A method according to any preceding claim wherein performing a measurement of the feature comprises measuring a depth of the feature.
